Europäisches Patentamt

European Patent Office

Office européen des brevets

(11) Publication number: **0 081 999**
**B1**

# EUROPEAN PATENT SPECIFICATION

(45) Date of publication of patent specification: **28.09.88**

(21) Application number: **82306614.7**

(22) Date of filing: **10.12.82**

(51) Int. Cl.⁴: **H 01 L 21/265,** H 01 L 21/28, H 01 L 29/08

(54) A method of fabricating a MOS transistor on a substrate.

(30) Priority: **16.12.81 US 331474**

(43) Date of publication of application:
**22.06.83 Bulletin 83/25**

(45) Publication of the grant of the patent:
**28.09.88 Bulletin 88/39** .

(84) Designated Contracting States:
**DE FR GB NL**

(56) References cited:
EP-A-0 036 573
GB-A-2 074 374
US-A-4 210 993

IBM TECHNICAL DISCLOSURE BULLETIN, vol. 24, no. 7A, December 1981, New York, US; F.H. De La MONEDA: "Masking technique to fabricate short-channel MOSFET for periphery of RAM chip"

(73) Proprietor: **INMOS CORPORATION**
**P.O. Box 16000**
**Colorado Springs Colorado 80935 (US)**

(72) Inventor: **Ryden, William D.**
**3348 Springridge Circle**
**Colorado Springs Colorado 80906 (US)**
Inventor: **Hanson, Matthew V.**
**11 West Cheyenne Boulevard**
**Colorado Springs Colorado 80906 (US)**
Inventor: **Derbenwick, Gary F.**
**1626 Vickers Drive**
**Colorado Springs Colorado 80907 (US)**
Inventor: **Gnadinger, Alfred P.**
**19 Leaming Road**
**Colorado Springs Colorado 80906 (US)**
Inventor: **Adams, James R.**
**1038 Oak Hills Drive**
**Colorado Springs Colorado 80919 (US)**

(74) Representative: **Palmer, Roger et al**
**Page, White and Farrer 5 Plough Place New Fetter Lane**
**London EC4A 1HY (GB)**

## Description

This invention relates to a method of fabricating a MOS transistor on a substrate. It is particularly directed to improved processing techniques for fabricating MOS (metal oxide semiconductor) transistors in a large scale integrated circuit.

A MOS transistor generally includes source/drain regions in a substrate, and a gate electrode formed above the substrate between the source/drain regions and separated from the substrate by a relatively thin dielectric. The relative alignment of the gate with its source/drain regions is an important factor which influences the performance of the transistor.

In some fabrication techniques, the edges of the source/drain regions are initially substantially vertically aligned with the edges of their gate. In subsequent heat treatment steps, however, the source/drain regions diffuse laterally. This results in the edges of the gate overlapping the source/drain regions. Consequently, undesired gate-drain overlap and Miller capacitances are created and the operating speed of the transistor is reduced.

IBM Technical Disclosure Bulletin, Volume 24, No. 7A, December 1981, pages 3417-3419, from which document the features in the pre-characterising part of claim 1 are known in combination, shows a technique for fabricating a MOS transistor in which an implant mask on the sides of the gate electrode shields an underlying portion of the substrate from implantation so that initially there is a gap between the side edge of the gate electrode and a side edge of the implanted region.

According to the present invention there is provided a method of fabricating on a substrate a MOS transistor having a gate electrode and at least one source/drain region comprising forming a gate electrode insulated from the substrate, forming an implant mask of a controlled width on the sides of the gate electrode, implanting at least one source/drain region in the substrate such that the implant mask shields an underlying portion of the substrate from implantation to provide a gap between a side edge of the gate electrode and a side edge of the implanted region, and subsequently driving the implanted source/drain region until its side edge is substantially aligned with the previously separated side edge of the gate electrode, characterised in that to ensure that no substantial gap or overlap exists between the source/drain region and the gate electrode the implant mask is formed by forming a first dielectric on the top of the gate electrode, forming a second dielectric over the first dielectric, over the sides of the gate electrode, and over the intended source/drain region, and etching the second dielectric where it overlies the intended drain/source region, whereby the second dielectric remaining on the sides of the gate electrode forms the implant mask, and in that the implanted source/drain region is heat driven into substantial alignment with the side edges of the gate electrode.

Embodiments of the present invention are described below, by way of example, with reference to the accompanying drawings, in which:-

FIGURES 1 to 4 illustrate in sequence the construction of an exemplary MOS transistor fabricated in accordance with the invention,

FIGURES 5 to 7 illustrate the formation of interconnects for a transistor constructed as shown in Figures 1 to 4,

FIGURE 8 is a simplified top view of a transistor fabricated as shown in Figures 1 to 7, and

FIGURES 9 and 10 illustrate how a MOS transistor is alternatively constructed with an implant mask of photoresist.

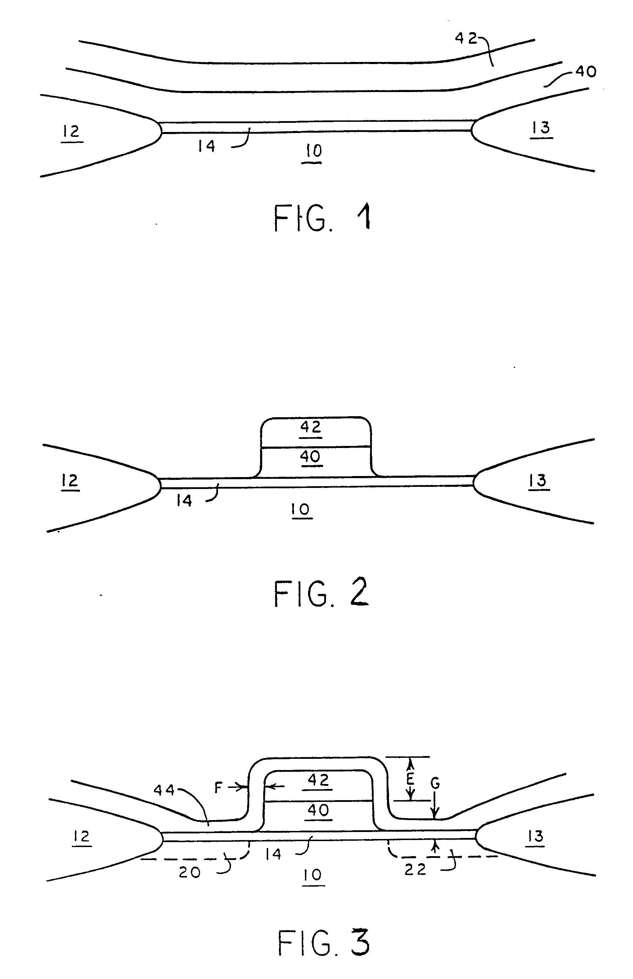

Referring to Figure 1, there is shown a substrate 10 on which field oxide regions 12 and 13 have been formed in any conventional manner, such as by local oxidation. Between these field oxide regions, an MOS transistor is fabricated by forming a dielectric layer 14, for example, of oxide. Again methods of forming the layer 14 are well known. A layer 40 of gate electrode material such as silicide, polysilicon, or other suitable material is formed over the dielectric layer 14. For example, the material of layer 40 may be polysilicon, referred to herein as Poly, and doped to a sheet resistance of about 20 ohms per square. Over the gate material 40, a further layer 42 of a dielectric, such as silicon dioxide or nitride, is formed. If the layer 42 is an oxide it may be either deposited or grown, but growing is preferred for better oxide integrity.

Using conventional patterning techniques, portions of the layers 40 and 42 are selectively removed to provide a gate structure as illustrated in Figure 2. As shown, the gate electrode material 40 is covered on its top by the dielectric 42. The gate structure is disposed above the transistor's intended channel and is insulated from the substrate by the gate oxide 14.

As shown in Figure 3, subsequently another dielectric layer 44 such as silicon dioxide is established over the dielectrics 42 and 14 and the field oxide regions 12 and 13. Consequently, this provides a composite dielectric having a thickness E over the gate electrode material 40, a thickness F on the sidewalls of the gate electrode material, and a thickness G over the substrate adjacent the gate electrode structure.

The structure shown in Figure 3 may then be dry etched to thin or even remove the dielectric 44 where it overlies the dielectric 42 and the intended source/drain regions 20 and 22.

The dry etch may be a plasma etch, for example, carried out in a reactive plasma etcher capable of anisotropic etching. A parallel plate reactor with close spacing (about 2 centimetres) between the plates is effective using 50% $CHF_3$ and 50% $C_2F_6$ at a total pressure of about O.93 mbar (700 millitors) and a power of about 2000 watts. This will result in a structure as shown in Figure 4.

As shown in Figure 4, a composite dielectric layer 18 formed by the layer 42 and overlying layer 44 has been established over a gate electrode 16, formed by the gate electrode material 40. Dielectric extends over the top and sides of the gate electrode 16 and over the substrate adjacent the gate electrode, the dielectric layer on the top and sides of the gate electrode being relatively thick compared to the dielectric layer adjacent the gate electrode over the intended source/drain regions. In one embodiment, the composite layer 18 is about 500 nanometres thick over the top (dimension A) of the gate electrode. The dielectric layer has a substantially similar thickness on the side (dimension B) of the gate electrode 16 but is relatively thin (dimension C) over the intended source/drain regions. The thickness of the dielectric layer at C will typically be about 170 nanometres. The thickness of the dielectric on the sides of the gate electrode 40 (dimension B) is chosen so that later implanted source and drain regions will be closely aligned with the vertical edges of the gate electrode 40 at the conclusion of transistor fabrication without any substantial gap or overlap between the source/drain regions and the gate electrode. That is, the dielectric on the sides of the gate electrode acts as an implant mask to shield underlying portions of the substrate from implantation.

Having established the dielectric layer 18, source/drain regions are implanted with arsenic or phosphorous, for example, to a depth which may be about 0.3 micron at a dose of about $6 \times 10^{15}$ ions per square centimetre. Because of the masking effect provided by the dielectric on the sides of the gate electrode 16, the source/drain regions 20 and 22 are not implanted adjacent the vertical edges of the gate electrode. Rather, a gap is provided between the gate electrode 16 and the source/drain regions to allow for subsequent diffusion of the source/drain regions.

In some applications, it is desirable to increase the thickness (dimension A) of the layer 18 in order to provide improved isolation. Also, it may be desirable to independently control or reduce the thickness C such as to implant the source/drain regions through a thinner dielectric or no dielectric at all. In these cases, an anisotropic etch, such as the plasma etch described above, may be used to remove or thin the dielectric layers which overlie the source/drain regions. By using an anisotropic etch, the sidewall dielectrics (dimension B) are not substantially thinned, such that the gap between gate electrode and the implanted source/drain regions can be about 500 nanometres. However, it may be desirable to modify the anisotropy of the etch to controllably thin the dielectric on the sidewall of the gate electrode to provide a smaller gap, 300 nanometres for example, where subsequent heat treatments are known to provide less lateral diffusion of the source/drain regions.

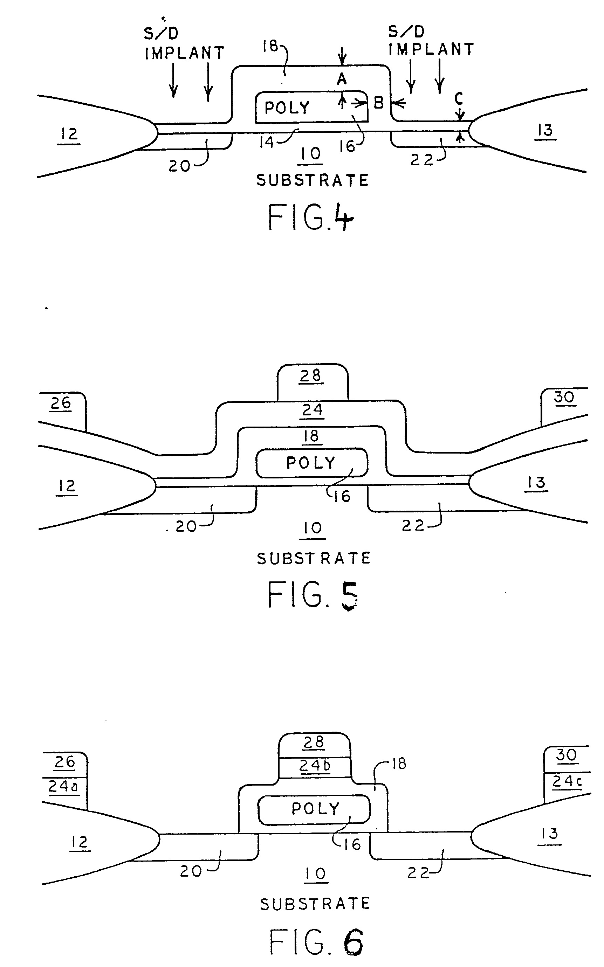

After the source/drain regions have been implanted, standard processing occurs, including heat treating the structure. During such heat treatment, the implanted source/drain regions are driven deeper (to about 0.7 micron, for example) and driven laterally into substantial alignment with the vertical edges of the gate electrode (Figure 5). Good alignment is achieved by establishing the thickness of the dielectric layer 18 on the sides of the gate electrode so that the known heat treatments which follow cause the edges of the source/drain regions to be driven laterally by a distance which is substantially equal to dimension B.

After the heat treatment, an intermediate oxide layer 24 is deposited to a depth of about 500 nanometres, for example. As shown in Figure 5, this intermediate oxide layer preferably covers the entire structure, including the field oxide regions 12 and 13.

Contact regions for the gate electrode and the source/drain regions are established by pattern-defining a photoresist layer at 26, 28 and 30. As shown a contact region is thus formed between photoresists 26 and 28. This contact region overlaps the field oxide region 12 and the gate electrode. A similar overlap is created in the area between photoresists 28 and 30.

Next, the dielectric layers 18 and 24 are removed from the contact areas so that the substrate is exposed above the source/drain regions, preferably by using a plasma etch as described above. The field oxide not masked by photoresist is also laid bare, and the unmasked dielectric layer 18 which overlies the gate electrode may be thinned.

At this point, it should be understood that the dielectric layers 18 and 24 may be made of either similar materials or different materials. It may be desired to use different materials to provide an etch stop which avoids thinning dielectric 18 over the gate electrode. For example, the composite dielectric 18 may contain a nitride layer and the dielectric 24 may be silicon dioxide.

Where the dielectrics 18 and 24 are of a similar material such as silicon dioxide, a thin layer of another dielectric such as a nitride may be deposited on the dielectric 18 prior to forming the dielectric 24. This also prevents etching from removing the dielectric 18 while the dielectric 24 is being removed. In any case, a dielectric layer 18 will remain on the gate 16 to facilitate the formation of self-aligned contacts or interconnects for the source/drain regions.

The directional etching described above provides the structure shown in Figure 6 in which an intermediate oxide layer 24a and a photoresist 26 are left over the illustrated portion of the field oxide 12. The illustrated portion of the field oxide 13 is covered by an intermediate oxide layer 24c and photoresist 30, and the central portion of the remaining oxide layer is covered by an intermediate oxide layer 24b and photoresist 28.

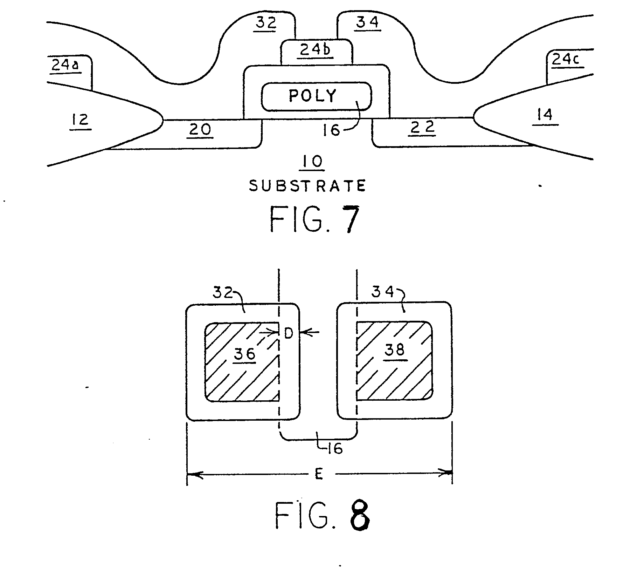

Referring now to Figure 7, the photoresists are removed in a conventional manner and an interconnect contacting layer 32, 34, such as aluminium or polysilicon, is provided so that the interconnect 32 overlies the source/drain region 20 and overlaps both the gate 16 and the field oxide 12. Likewise, the interconnect 34 overlies the source/drain region 22 and overlaps both the gate 16 and the field oxide region 13. These interconnect patterns may be used to electrically contact the source/drain and gate regions in the usual manner.

The fabrication technique described above has several advantages. Chief among these is the lack of undesired overlap between the finally processed source/drain regions and the gate electrode. Consequently, the transistor has reduced Miller capacitance and, therefore, operates faster. In addition, the width of the gate is substantially equal to the transistor's electrical channel length. This allows transistors with longer channel characteristics to be fabricated with smaller physical dimensions.

The fabrication technique described also allows the substrate to be etched over the source/drain regions whilst the dielectric layer 18 protects the gate 16. Even if the photoresist 28 is misaligned with respect to the gate, the dielectric 18 prevents shorts to the gate when the interconnects 32, 34 are provided for the source/drain regions.

The manner in which the interconnects are provided also contributes substantially to a reduction in transistor size. As shown in the simplified top view depicted in Figure 8, the interconnect patterns 32 and 34 overlap the gate 16 whilst covering the active areas designated by shaded regions 36 and 38. Typically, the gate and the active areas are about 2 microns wide, and an overlap of about .5 microns (dimension D) exists between the interconnect patterns and the gate. Consequently, the size (dimension E) of the transistor is reduced to about 7 microns or less.

Several alternatives are available for practicing the present fabrication technique. For example, the use of the intermediate oxide layer 24 may be eliminated and contact areas may be defined by a non-selective etch. The resulting structure would be substantially as shown in Figure 7, except that the intermediate oxide would not be present. This technique is useful in forming self-aligned buried contacts.

In addition, a nitrogen implant may be used prior to forming the oxide layer 44 (Figure 3) to reduce the rate of oxidation over the source/drain regions whilst not affecting the rate of oxidation on the gate structure.

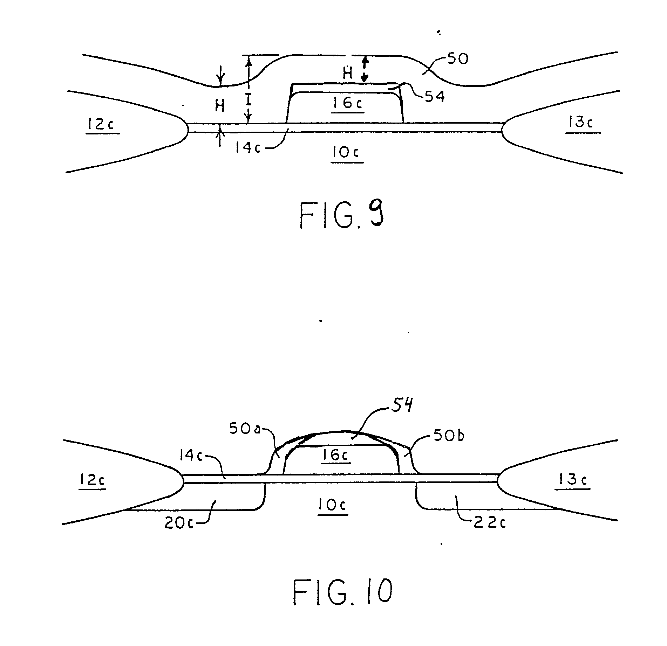

Figure 9 shows a variant of the method described above for ensuring proper alignment of the source/drain regions. In Figure 9, materials and structure which correspond to the materials and structure of Figures 1 to 4 have corresponding reference numerals followed by the character "c".

As can be seen from Figure 9, a dielectric layer 14c is established over the substrate 10c in the usual manner, and a gate structure is defined over the intended channel of the transistor by the method shown in Figures 1 and 2. The gate structure thus comprises the gate electrode 16c and a dielectric layer 54 on top of the gate electrode 1.

A layer of photoresist material 50 is then established in a conventional manner over the entire structure. This results in a layer of photoresist having a depth H over the intended source/drain regions and over the dielectric layer 54. A greater depth I of photoresist occurs in the areas adjacent the sides of the gate electrode.

The photoresist is then exposed and developed conventionally or anisotropically etched so as to remove a thickness H of it. Because of the greater depth of the photoresist at the areas adjacent the gate electrode photoresist remnants or fillets 50a and 50b (Figure 10) remain on the sides of the gate electrode. These fillets serve, of course, to mask the source/drain implantation as described in the other examples.

The source/drain regions 20c and 22c may now be implanted. The oxide layer 54 prevents the gate material being doped during this implantation.

After the structure shown in Figure 10 has been obtained, the photoresist fillets 50a and 50b are stripped away in known manner and an oxide layer is then established over the entire structure which thus resembles that shown in Figure 4. Next, the previously described processing occurs, including the heat treatment which drives the source/drain regions 20c and 22c into non-overlapping alignment with the vertical edges of the gate electrode 16c.

In the methods described above for fabricating an MOS device, an implant mask is provided which ensures that the source/drain regions are properly aligned with the gate electrode at the conclusion of fabrication. In addition, the implant mask serves to isolate the gate electrode, particularly its edges, from interconnects so that the patterns which define the interconnects need not be held to tight tolerances.

## Claims

1. A method of fabricating on a substrate a MOS transistor having a gate electrode and at least one source/drain region comprising forming a gate electrode (16) insulated from the substrate (10), forming an implant mask (18) of a controlled width on the sides of the gate electrode (16), implanting at least one source/drain region (20, 22) in the substrate (10) such that the implant mask (18) shields an underlying portion of the substrate (10) from implantation to provide a gap between a side edge of the gate electrode (16) and a side edge of the implanted region (20, 22), and subsequently driving the implanted source/drain region (20, 22) until its side edge is substantially aligned with the previously separated side edge of the gate electrode (16), characterised in that to ensure that no substantial gap or overlap exists between the source/drain region and the gate electrode the implant mask is formed by forming a first dielectric (42, 54) on the top of the gate electrode (40, 16c), forming a second dielectric (44, 50) over the first dielectric (42, 54), over the sides of gate electrode, and over the intended source/drain region (20, 22), and etching the second dielectric (44, 50) where it overlies the

4

intended drain/source region, whereby the second dielectric remaining on the sides of the gate electrode (40) forms the implant mask, and in that the implanted source/drain region (20, 22) is heat driven into substantial alignment with the side edges of the gate electrode.

2. A method as claimed in Claim 1, wherein said second dielectric (50) is a photoresist.

3. A method as claimed in Claim 2, wherein said photoresist layer (50) is formed over the first dielectric (54) on the gate electrode (16c), and over the intended source/drain region (20c, 22c) such that a greater depth (I) of photoresist occurs adjacent the edges of the gate electrode (16c) than over the top of the first dielectric (54) and over other areas of the intended source/drain region, and wherein the photoresist is removed from the top of the first dielectric and from the source/drain region so as to leave photoresist remnants (50a, 50b) on the sides of the gate electrode (16c).

4. A method as claimed in Claim 1, wherein said first dielectric (42) and said second dielectric (44) define a composite dielectric layer (18) over the gate electrode (16), the dielectric on the top and sides of the gate electrode (16) being relatively thick compared to the dielectric over the substrate such that the source/drain implantation is masked by the relatively thick dielectric (B) on the sides of the gate electrode.

5. A method as claimed in Claim 4, wherein the source/drain region (20, 22) is implanted through the relatively thin dielectric layer over the substrate.

6. A method as claimed in Claim 4, wherein prior to implanting the source/drain region (20, 22), the dielectric (18) is anisotropically etched so as to remove dielectric over the intended source/drain region and yet maintain masking dielectric (B) on the sides of the gate electrode (16).

7. A method as claimed in any preceding claim, including, after implantation, forming an intermediate dielectric (24) over the resultant structure, patterning a contact area over the source/drain region (20, 22) so that the contact area overlies the source/drain region and overlaps the implant mask on the gate electrode (16), etching the contact area down to the substrate (10) while leaving the implant mask (18) on the sides and top of the gate electrode (16), and providing a conductive material (32, 34) in the etched contact area to provide a contact for the source/drain region (20, 22) whereby a self-aligned contact is formed such that the gate electrode (16) is prohibited by the implant mask (18) from being shorted in the event the patterned contact area is misaligned.

**Patentansprüche**

1. Verfahren für die Herstellung eines MOS-Transistors auf einem Substrat, mit einer Gate-Elektrode und mindestens einer Source-Drain-Zone, wobei eine vom Substrat (10) isolierte Gate-Elektrode (16) ausgebildet und eine implantierte Maske (18) von vorgegebener Breite an den Seiten der Gate-Elektrode (16) geformt wird, sodann mindestens eine Source-Drain-Zone (20, 22) in das Substrat (10) dergestalt implantiert wird, daß die implantierte Maske (18) einen darunterliegenden Teil des Substrats (10) gegen eine Implantierung abschirmt, um eine Lücke zwischen einem Seitenrand der Gate-Elektrode (16) und einem Seitenrand der implantierten Zone (20, 22) zu bilden, und wobei anschließend die implantierte Source-Drain-Zone (20, 22) vorgetrieben wird bis ihr Seitenrand im wesentlichen mit dem zuvor abstehenden Seitenrand der Gate-Elektrode (16) fluchtet, dadurch gekennzeichnet, daß zur Vermeidung einer wesentlichen Lücke oder Überlappung zwischen der Source-Drain-Zone und der Gate-Elektrode die implantierte Maske dergestalt ausgebildet wird, daß zunächst ein erstes Dielektrikum (42, 54) über der Gate-Elektrode (40, 16c) und ein zweites Dielektrikum (44, 50) über dem ersten Dielektrikum (42, 54), über den Seiten der Gate-Elektrode und über der vorgesehenen Source-Drain-Zone (20, 22) geformt und sodann das zweite Dielektrikum (44, 50) dort abgeätzt wird, wo es über der vorgesehenen Source-Drain-Zone liegt, wobei das an den Seiten der der Gate-Elektrode (40) verbleibende zweite Dielektrikum die implantierte Maske bildet, und daß die implantierte Source-Drain-Zone (20, 22) durch Erhitzung so weit vorgetrieben wird, daß sie im wesentlichen mit den Seitenrändern der Gate-Elektrode fluchtet.

2. Verfahren nach Anspruch 1, dadurch gekennzeichnet, daß das zweite Dielektrikum (50) ein Photoresist ist.

3. Verfahren nach Anspruch 2, dadurch gekennzeichnet, daß die Photoresist-Schicht (50) über dem ersten Dielektrikum (54) an der Gate-Elektrode (16c) und über der vorgesehenen Source-Drain-Zone (20c, 22c) dergestalt geformt wird, daß eine größere Tiefe (I) der Photoresist-Schicht an den Rändern der Gate-Elektrode (16c) entsteht als über dem ersten Dielektrikum (54) und über den sonstigen Bereichen der vorgesehenen Source-Drain-Zone, und daß das Photoresist oberhalb des ersten Dielektrikums und über der Source-Drain-Zone entfernt wird, so daß Photoresist-Reste (50a, 50b) an den Seiten der Gate-Elektrode (16c) verbleiben.

4. Verfahren nach Anspruch 1, dadurch gekennzeichnet, daß das erste Dielektrikum (42) und das zweite Dielektrikum (44) eine zusammengesetzte Dielektrikum-Schicht (18) über der Gate-Elektrode (16) bilden, wobei das Dielektrikum oberhalb und an den Seiten der Gate-Elektrode (16) verhältnismäßig dick im Vergleich zu dem Dielektrikum über dem Substrat ist, so daß die Source-Drain-Implantierung durch das verhältnismäßig dicke Dielektrikum (B) an den Seiten der Gate-Elektrode ausgespart wird.

5. Verfahren nach Anspruch 4, dadurch gekennzeichnet, daß die Source-Drain-Zone (20, 22) durch die verhältnismäßig dünne Dielektrikum-Schicht über dem Substrat implantiert wird.

6. Verfahren nach Anspruch 4, dadurch gekennzeichnet, daß vor dem Implantieren der Source- Drain-Zone (20, 22) das Dielektrikum (18) anisotrop abgeätzt wird, so daß das Dielektrikum über der vorgesehenen Source-Drain-Zone entfernt wird und dennoch eine Dielektrikum-Abdekkung (B) an den Seiten der Gate-Elektrode (16) erhalten bleibt.

7. Verfahren nach einem der vorangehenden Ansprüche, dadurch gekennzeichnet, daß nach der Implantierung ein Zwischen-Dielektrikum (24) über der entstandenen Struktur ausgebildet und eine Kontaktzone über der Source-Drain-Zone (20, 22) geformt wird, so daß die Kontaktzone über der Source-Drain-Zone liegt und die implantierte Maske an der Gate-Elektrode (16) überlappt, daß die Kontaktzone bis zum Substrat (10) hinunter abgeätzt, dabei aber die implantierte Maske (18) an den Seiten und oberhalb der Gate-Elektrode (16) stehengelassen wird, und daß ein leitfähiges Material (32, 34) in die abgeätzte Kontaktzone gebracht wird, um einen Kontakt für die Source-Drain-Zone (20, 22) zu erzeugen, wodurch ein selbstjustierter Kontakt dergestalt gebildet wird, daß ein Kurzschluß der Gate-Elektrode (16) im Fall einer Fehljustierung der geformten Kontaktzone durch die implantierte Maske (18) verhindert wird.

**Revendications**

1. Procédé de fabrication sur un substrat d'un transistor MOS ayant une électrode de grille et au moins une région source/drain, consistant à former une électrode de grille (16) isolée du substrat (10), à former un masque à implant (18) d'une largeur contrôlée sur les côtés de l'électrode de grille (16), à implanter au moins une région source/drain (20, 22) dans le substrat (10) afin que le masque à implant (18) protège d'une implantation une partie sousjacente du substrat (10) pour former un intervalle entre un bord latéral de l'électrode de grille (16) et un bord latéral de la région implantée (20, 22), et à mener ensuite la région source/drain implantée (20, 22) jusqu'à ce que son bord latéral soit sensiblement aligné avec le bord latéral, précédemment séparé, de l'électrode de grille (16), caractérisé en ce que, pour s'assurer qu'aucun intervalle ou chevauchement sensible n'existe entre la région source/drain et l'électrode de grille, on forme le masque à implant en formant un premier diélectrique (42, 54) sur le dessus de l'électrode de grille (40, 16c), en formant un second diélectrique (44, 50) sur le premier diélectrique (42, 54), sur les côtés de l'électrode de grille et sur la région prévue source/drain (20, 22), et en attaquant le second diélectrique (44, 50) où il recouvre la région prévue drain/source, de manière que le second diélectrique restant sur les côtés de l'électrode de grille (40) forme le masque à implant, et en ce que la région implantée source/drain (20, 22) est menée par la chaleur sensiblement en alignement avec les bords latéraux de l'électrode de grille.

2. Procédé selon la revendication 1, dans lequel ledit second diélectrique (50) est une résine photosensible.

3. Procédé selon la revendication 2, dans lequel ladite couche (50) de résine photosensible est formée sur le premier diélectrique (54) au-dessus de l'électrode de grille (16c), et sur la région prévue source/drain (20c, 22c) afin qu'une plus grande profondeur (l) de résine photosensible apparaisse au voisinage immédiat des bords de l'électrode de grille (16c) que sur le dessus du premier diélectrique (54) et sur d'autres zones de la région prévue source/drain, et dans lequel la résine photosensible est enlevée du dessus du premier diélectrique et de la région source/drain afin qu'il reste des vestiges de résine photosensible (50a, 50b) sur les côtés de l'électrode de grille (16c).

4. Procédé selon la revendication 1, dans lequel ledit premier diélectrique (42) et ledit second diélectrique (44) définissent une couche diélectrique composite (18) sur l'électrode de grille (16), le diélectrique situé sur le dessus et les côtés de l'électrode de grille (16) étant relativement épais en comparaison avec le diélectrique sur le substrat afin que l'implantation source/drain soit masquée par le diélectrique relativement épais (B) sur les côtés de l'électrode de grille.

5. Procédé selon la revendication 4, dans lequel la région source/drain (20, 22) est implantée à travers la couche diélectrique relativement mince sur le substrat.

6. Procédé selon la revendication 4, dans lequel, avant l'implantation de la région source/drain (20, 22), le diélectrique (18) est attaqué de façon anisotrope afin d'enlever le diélectrique au-dessus de la région prévue source/drain tout en maintenant un diélectrique de masquage (B) sur les côtés de l'électrode de grille (16).

7. Procédé selon l'une quelconque des revendications précédentes, consistant, après l'implantation, à former un diélectrique intermédiaire (24) sur la structure résultante, à configurer une zone de contact sur la région source/drain (20, 22) afin que la zone de contact recouvre la région source/drain et chevauche le masque à implant sur l'électrode de grille (16), à attaquer la zone de contact jusqu'au substrat (10) tout en laissant le masque à implant (18) sur les côtés et le dessus de l'électrode de grille (16), et à fournir une matière conductrice (32, 34) dans la zone de contact attaquée pour réaliser un contact pour la région source/drain (20, 22) afin qu'un contact auto-aligné soit formé pour que l'électrode de grille (16) soit protégée, par le masque à implant (18), d'un court-circuit dans le cas d'un défaut d'alignement de la zone de contact configurée.

FIG. 1

FIG. 2

FIG. 3

FIG.4

FIG. 5

FIG. 6

FIG. 7

FIG. 8

FIG. 9

FIG. 10